Europäisches Patentamt

European Patent Office

Office européen des brevets

(11) Publication number: **0 397 034**
**A1**

## (12) EUROPEAN PATENT APPLICATION

(21) Application number: **90108387.3**

(22) Date of filing: **03.05.90**

(51) Int. Cl.⁵: **H01L 27/105, H01L 27/11, H01L 21/82, H01L 29/784, G11C 11/412**

The title of the invention has been amended (Guidelines for Examination in the EPO, A-III, 7.3).

(30) Priority: **09.05.89 JP 114137/89**

(43) Date of publication of application:
**14.11.90 Bulletin 90/46**

(84) Designated Contracting States:
**DE FR GB IT**

(71) Applicant: **HITACHI, LTD.**
**6, Kanda Surugadai 4-chome**
**Chiyoda-ku, Tokyo 100(JP)**

Applicant: **HITACHI VLSI ENGINEERING CORPORATION**
**20-1, Jousuihoncho 5-chome**
**Kodaira-shi Tokyo(JP)**

(72) Inventor: **Hashimoto, Takashi**
**Owada Apartement D-203, 47-1**
**Akatsukicho-1-chome, Hachioji-shi(JP)**
Inventor: **Kobayashi, Takashi**
**Hitachi Daiyon Kyoshinryo 14-6**
**Nishikoigakubo 4-chome, Kokubunji-shi(JP)**
Inventor: **Yamanaka, Toshiaki**
**Gurinkoto B-105, 8-28, Shimohoya 2-chome**
**Hoya-shi(JP)**
Inventor: **Mine, Toshiyuki**
**2050-1-102 Hane, Hamuramachi**
**Nishitama-gun, Tokyo(JP)**
Inventor: **Shimizu, Akihiro**
**5-7 Mihoricho 5-chome**
**Akishima-shi(JP)**

(74) Representative: **Strehl, Schübel-Hopf, Groening**
**Maximilianstrasse 54 Postfach 22 14 55**
**D-8000 München 22(DE)**

(54) **SRAM device using an ultra thin polycristalline Si film, and its manufacturing method.**

(57) There is disclosed a static type random access memory in which a high polycrystalline silicon resistor comprising a polycrystalline silicon film (23) of a thickness of 30 nm or less or an MISFET (362) using the polycrystalline silicon film (23) as a channel is used as a load.

$BF_2^+$

**F I G. 2A**

## SEMICONDUCTOR DEVICE AND ITS MANUFACTURING METHOD

BACKGROUND OF THE INVENTION

The present invention relates to a semiconductor device such as polycrystalline silicon resistors each having an extremely high resistivity, an MIS type field effect transistor (hereinafter, referred to as an MISFET) in which an off-current, subthreshold characteristics, threshold voltage, short channel effect, and the like are improved by a thin film effect, a static type random access memory (hereinafter, referred to as an SRAM) which uses the polycrystalline silicon resistors or MISFET and in which an electric power consumption in the standby mode is very low, or the like. The invention also relates to a method of manufacturing a semiconductor device to realize such semiconductor devices.

For instance, a structure of a conventional MISFET and its manufacturing method have been disclosed in H. Shichijo, et al., "Characterization of N-Channel and P-Channel LPCVD Polycrystalline silicon MOSFETs", IEDM 83, Technical Digest, IEEE, pp. 202 - 205, 1983.

In the above literature, there is disclosed an MISFET having a structure (lower gate structure) in which a gate electrode is provided on the lower side of a channel region and a structure (upper gate structure) in which a gate electrode is provided on the upper side of the channel region (current path).

In the MISFET having the lower gate structure, first, a gate electrode comprising an n type polycrystalline Si is directly formed on an n type Si wafer. Then, the surface of the gate electrode is thermally oxidized and a silicon oxide film ($SiO_2$ film) having a thickness of 35 nm is formed as a gate insulative film. Then, a polycrystalline Si film having a thickness of 150 nm is deposited onto the gate insulative film at a deposition temperature of $620\,^\circ$C by a chemical vapor deposition method using $SiH_4$ as a source gas and is worked into a predetermined shape by dry etching. After that, impurities for doping are doped into a predetermined region of the polycrystalline Si film by using an ion implantation method, thereby forming source and drain regions. A region between the source and drain regions formed in the polycrystalline Si film is a channel region.

On the other hand, in the MISFET having the upper gate structure, the surface of a p type Si wafer is thermally oxidized and a silicon oxide film having a thickness of 500 nm is formed. A polycrystalline Si film having a thickness of 150 nm is deposited onto the silicon oxide film by the same method as above. The polycrystalline Si film is worked into a predetermined shape. After that, the surface of the polycrystalline Si film is thermally oxidized and a silicon oxide film having a thickness of 50 nm is formed as a gate insulative film. Subsequently, a gate electrode of polycrystalline Si is formed onto the gate insulative film. Thereafter, impurities are doped into the gate electrode by using an ion implantation method by self aligning, thereby forming source and drain regions. A region between the source and drain regions formed in the polycrystalline Si film is a channel region.

The MISFET is which the channel region is formed in the polycrystalline silicon film is referred to as a polycrystalline Si-MISFET hereinbelow.

As mentioned above, in any of the above cases, a thermal oxide film is used as an under insulative film when depositing the polycrystalline Si film in which the channel region (current path) is formed. A thickness of polycrystalline Si film is set to 150 nm. In the p channel of the MISFET, it has been reported that an off-current ($V_G$ = OV) is set to $10^{-11}$ A/um and an on-current when a gate voltage $V_G$ = -3V is set to $10^{-3}$ A/$\mu$m (those values relate to the case of no hydrogen passivation).

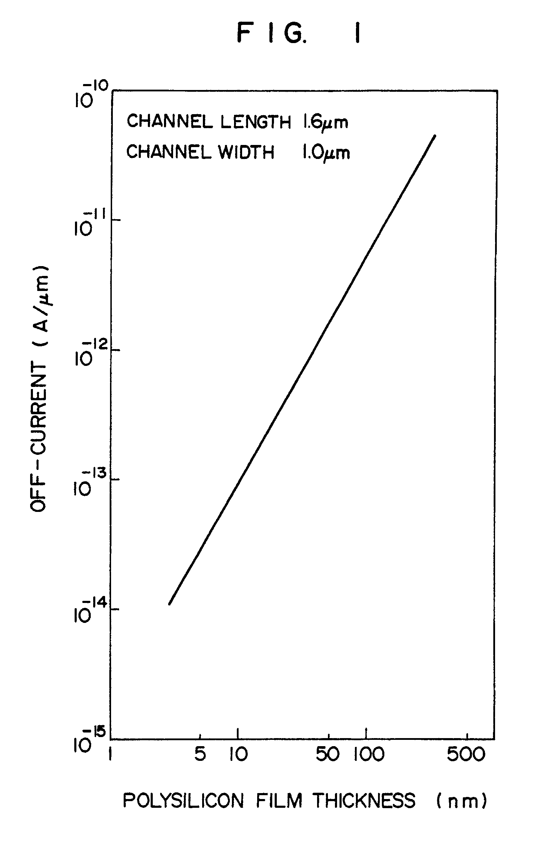

In the SRAM having a backup function by a battery, in one megabits, it is required that an amount of current consumption per chip is set to a value within a range from 1 to 2 $\mu$A or less. The amount of current consumption per chip is expressed by the product of an amount of current consumption per bit and the number of bits. Therefore, to keep the backup life by the battery constant irrespective of a degree of packing density, the amount of current consumption per bit must be reduced with an increase in degree of packing density. The amount of current consumption depends on the off-current of the MISFET of polycrystalline Si. Further, the off-current largely depends on a film thickness of polycrystalline Si in the channel portion. Fig. 1 shows the relation of the off-current and the thickness of polycrystalline Si film. An impurity concentration of polycrystalline Si used here is set to 1 x $10^{17}$ cm$^{-3}$ or less, so that such a film region is substantially a non-doped region. Therefore, it will be understood that in order to reduce the off-current, it is effective to make the polycrystalline Si film thin. This is because the off-current is generated in the junction at the drain edge and the junction area decreases due to the realization of the thin film.

According to Fig. 1, when the polycrystalline silicon film thickness is set to 40 nm, the off-current is set to about 1 pA/bit. In the future, in order to realize the high packing density such as 4 or 16 megabits, the polycrystalline silicon film thickness must be made thin and the off-current must be reduced to 1/4 or 1/16, respectively, from the above reasons.

In order to realize the high packing density of the SRAM having the MISFET which was manufactured by using the conventional technique, a thickness of polycrystalline Si film in which the channel region is formed was made thin. Thus, it has been found by the examination of the present inventors that when the film thickness is about 30 nm or less, polycrystalline silicon is formed like an island or a hole exists, so that a uniform film is not obtained.

Therefore, as will be obvious from Fig. 1, in such a state, it is difficult to realize the SRAM of 4 megabits or more.

In JP-A-59-111368, there has been disclosed an MISFET having a lower gate structure in which a polycrystalline silicon film in which a channel region is formed on a silicon dioxide film which was formed by the CVD method instead of on the thermal silicon oxide film. In the above Official Gazette, there have been disclosed the fact that the silicon dioxide film was formed at temperatures of 850°C or more by the CVD method by using mixture gases of $SiH_2Cl_2$ and $N_2O$ and the fact that a fixed charge in the silicon dioxide film was set to $5 \times 10^{10}/cm^2$ or less. However, nothing is disclosed with respect to the thickness of polycrystalline silicon film formed on the silicon dioxide film.

## SUMMARY OF THE INVENTION

It is an object of the present invention to provide an MISFET or polycrystalline silicon resistor using an ultra-thin Si film having an off-current value as mentioned above.

Another object of the invention is to provide an SRAM which uses such an MISFET or polycrystalline silicon resistor and in which an electric power consumption in the standby mode is extremely small.

Further another object of the invention is to realize an ultra-thin Si film having a thickness of 30 nm or less and to provide a method of manufacturing those semiconductor devices.

To accomplish the above object, as an under insulative film when an ultra-thin Si film is deposited by the low pressure chemical vapor deposition method, in place of a thermal silicon oxide film, there is used an insulative film such as $SiO_2$ film, $Si_3N_4$ film, or the like which was formed by a chemical vapor deposition method (hereinafter, referred to as a CVD method) such as low pressure chemical vapor deposition method (hereinafter, referred to as an LPCVD method), atmospheric pressure chemical vapor deposition method (hereinafter, referred to as an APCVD method), or the like. On the other hand, Si ions are implanted into the surface of the under insulative film.

As a source gas to deposit the ultra-thin Si film, a gas of the silane system such as monosilane ($SiH_4$), disilane ($Si_2H_6$), trisilane ($Si_3H_8$), etc. can be used.

Thus, the film which thickness is uniformly continuous until the film thickness of 3 nm can be formed.

To form a polycrystalline Si resistor having an extremely high resistivity, the ultra-thin Si film having a thickness within a range from 3 to 30 nm which was manufactured by the above manufacturing method is used.

Further, to obtain an MISFET of polycrystalline Si having an extremely low off-current value, the ultra-thin Si film is used as a channel region.

In addition, to obtain an SRAM whose electric power consumption in the standby mode is extremely small, the polycrystalline silicon resistor is used as a load.

## BRIEF DESCRIPTION OF THE DRAWINGS

Fig. 1 is a diagram showing the relation between the thickness of polycrystalline Si film of an MISFET having the polycrystalline Si film as a channel and the off-current;

Figs. 2A to 2C, 3A to 3C, and 5A to 5C are structural cross sectional views showing manufacturing steps of MISFETs according to embodiments of the present invention;

Figs. 4A to 4E are an equivalent circuit diagram and structural cross sectional views showing manufacturing steps of an SRAM according to an embodiment of the invention;

Fig. 6 is a diagram showing the relation between the gate voltage $V_G$ and the drain current $I_D$ of the MISFET according to the invention;

Fig. 7 is a diagram showing the relation between the thickness of polycrystalline Si film and the off-current of the MISFET according to the invention;

Fig. 8 is a diagram showing the relation between the thickness of polycrystalline Si film and the on-current ($V_G = -3V$) of the MISFET according to the invention;

Fig. 9 is a diagram showing the relation between the design channel length and $\Delta V_{th}$ of the MISFET according to the invention; and

Fig. 10 is a diagram showing the relation between the thickness of polycrystalline Si film of the MISFET according to the invention and the subthreshold swing (S factor).

DESCRIPTION OF THE PREFERRED EMBODIMENTS

The growth of an ultra-thin Si film onto an insulative film will be first described.

At the initial stage of the deposition of an Si film by the CVD method, nuclei are generated on the insulative film at a certain probability and, further, the nuclei grow and become island-like regions. Further, as the deposition time elapses, the collision of the islands occurs and a continuous film is finally formed. Therefore, to form a thinner continuous film, it is considered that it is necessary to raise a nucleus generation density on the under insulative film.

Therefore, a method of forming the insulative film was changed or various processes are executed after the insulative film was formed, and examinations were made with respect to the realization of a thin polycrystalline Si film. Thus, it has been found that an Si film having a thickness of 30 nm or less is grown onto the $SiO_2$ film which was formed by the CVD method. The invention is made on the basis of the above discovery.

On the surface of the $SiO_2$ film which was formed by the CVD method, there are more positions where the adsorbed Si particles are captured as compared with the surface of the $SiO_2$ film which was formed by the thermal oxidation. Thus, the diffusion on the surface of the $SiO_2$ film is difficult, the nucleus density at the initial stage of the formation of the Si film is high, and a denser film is formed. Therefore, it is considered that the ultra-thin Si film having a thickness of 30 nm or less could be formed as a continuous film. On the other hand, the same shall also apply to the surface of the $Si_3N_4$ film formed by the CVD method or the surface of the insulative film in which Si ions were implanted.

It will be obviously understood that the high polycrystalline silicon resistor using the ultra-thin Si film obtained by the above forming method has a higher resistivity as compared with the conventional polycrystalline silicon resistor.

The MISFET using the ultra-thin Si film as a channel has an extremely low off-current value. Further, when the film thickness is set to 20 nm or less, the MISFET characteristics such as subthreshold characteristics, threshold voltage, short channel effect, and the like are largely improved because of the following reasons.

An inverse number of the inclination of the subthreshold region in the ordinary MISFET, that is, an S factor is expressed by the following equation.

$$S = kT/q \ln 10 (1 + (C_{it} + C_d)/C_{ox})$$

In the above equation,

$C_{ox}$: gate insulative film capacity,

$C_d$: depletion layer capacity,

$C_{it}$: interfacial state capacity containing defects in the polycrystalline Si film,

k: Boltzmann's constant,

q: charge of electron,

T: absolute temperature.

In the MISFET of polycrystalline Si, since a number of defects are included in the polycrystalline Si film and at the interface with the insulative film, ordinarily, there is a relation of $C_{it} \gg C_d$. In the case of $C_{it}$, particularly, since the contribution of the defects contained in the channel is large, if a thickness of polycrystalline Si film is set to be thinner than a thickness (ordinarily, 20 nm or less) of channel, the value of $C_{it}$ decreases and the value of S factor also decreases. In association with the decreases in $C_{it}$ and S factor, the threshold voltage which was defined as a gate voltage which gives a predetermined drain current value also decreases. Further, in the MOSFET of monocrystalline Si on the insulative film (SOI), it has been reported that by making the Si film thickness sufficiently thin, the short channel effect is suppressed in the literature by T. Sekigawa et al., "Calculated Threshold-Voltage Characteristics of an XMOS Having an Additional Bottom Gate", Solid-State Electron, Vol. 27, No. 819, page 827, 1984. The similar improvement can be also accomplished even in the case of polycrystalline Si.

On the other hand, in the SRAM using the above polycrystalline silicon resistor as a load, an extremely low electric power consumption can be accomplished.

In the SRAM using the above MISFET as a load, it has been found that not only an extremely low electric power consumption can be accomplished but also the excellent data retention characteristics are obtained and the soft error immunity is high.

[Embodiments]

Embodiment 1

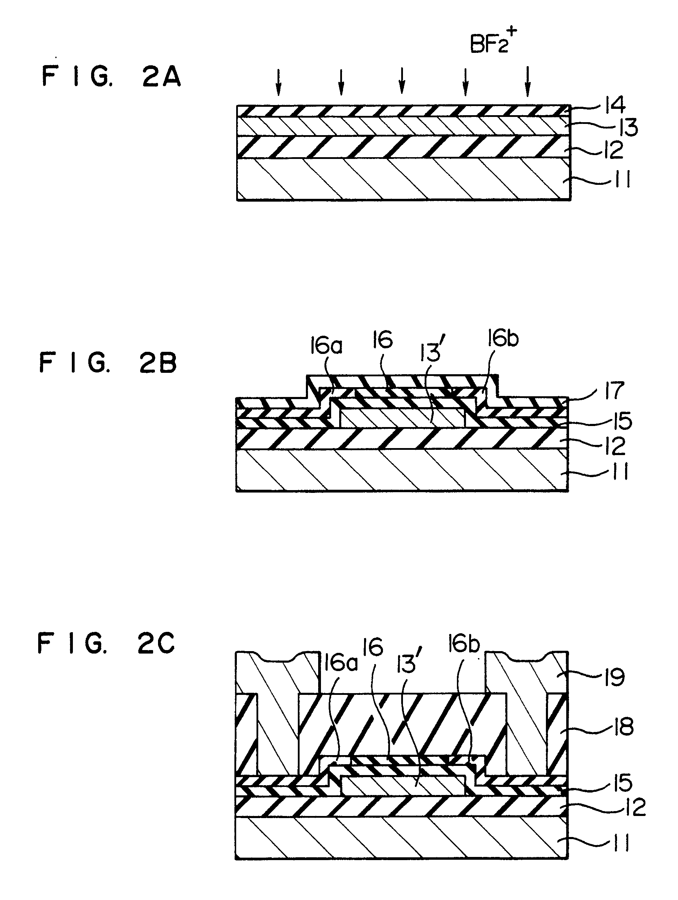

An example of a manufacturing method of the MISFET according to the invention will now be described with reference to Figs. 2A to 2C.

An $SiO_2$ film 12 is formed by thermally oxidizing the surface of a p type Si substrate 11. A polycrystalline Si film 13 is deposited onto the $SiO_2$ film 12 by the LPCVD method. Further, an $SiO_2$ film 14 is deposited onto the polycrystalline silicon film 13 by the LPCVD method. After that, ions of $BF_2^+$ are implanted into the polycrystalline silicon film 13 (Fig. 2A) and B ions are doped.

Then, the thermal annealing is executed and impurities are activated. After that, the wet etching is executed in the aqueous solution of the HF system and the $SiO_2$ film 14 is eliminated. Then, a photo resist pattern is used as a mask and the polycrystalline silicon film 13 is processed by the dry etching method, thereby obtaining a gate electrode 13'. An $SiH_4$ gas and an $N_2O$ gas are used as source gases and an $SiO_2$ film 15 of a thickness of 25 nm is deposited at a temperature of 800°C by the LPCVD method. Subsequently, the heat treatment is executed in the $N_2$ gas atmosphere at 900°C for ten minutes, thereby forming a gate oxide film. Then, a silane gas ($SiH_4$, $Si_2H_6$, or $Si_3H_6$) is used as a source gas and an Si film 16 of a thickness of 10 nm is deposited onto the gate oxide film 15 at a temperature of 520°C by the LPCVD method. A photo resist pattern is used as a mask and the Si film 16 is processed into a predetermined shape by the dry etching method. Then, an $SiO_2$ film 17 is deposited by the LPCVD method. A photo resist pattern is used as a mask and ions of $BF_2{}^+$ are implanted, thereby forming p type high concentration impurity regions ($p^+$ doped regions) 16a and 16b serving as a source and a drain (Fig. 2B).

An $SiO_2$ film is then formed by the CVD method. A layer of BPSG (silicate glass containing boron and phosphorus) is deposited onto the $SiO_2$ film by the CVD method, thereby forming an interlayer insulative film 18. After the reflow was executed, a photo resist having a desired pattern is used as a mask and a contact is formed by the dry etching method. Subsequently, an Al-Si film 19 is deposited and a photo resist is used as a mask and a wiring pattern is formed by the dry etching method. After that, the heat treatment is executed in the $H_2$ gas atmosphere at 450°C for 30 minutes (Fig. 2C).

In the p channel MOSFET of polycrystalline Si which was manufactured by the embodiment, the source electrode was grounded, a voltage was applied to the drain and gate electrodes, and a drain current was measured.

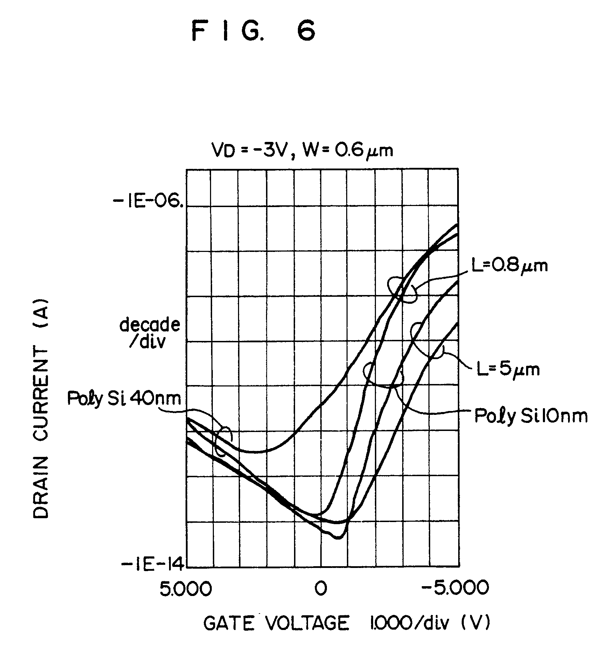

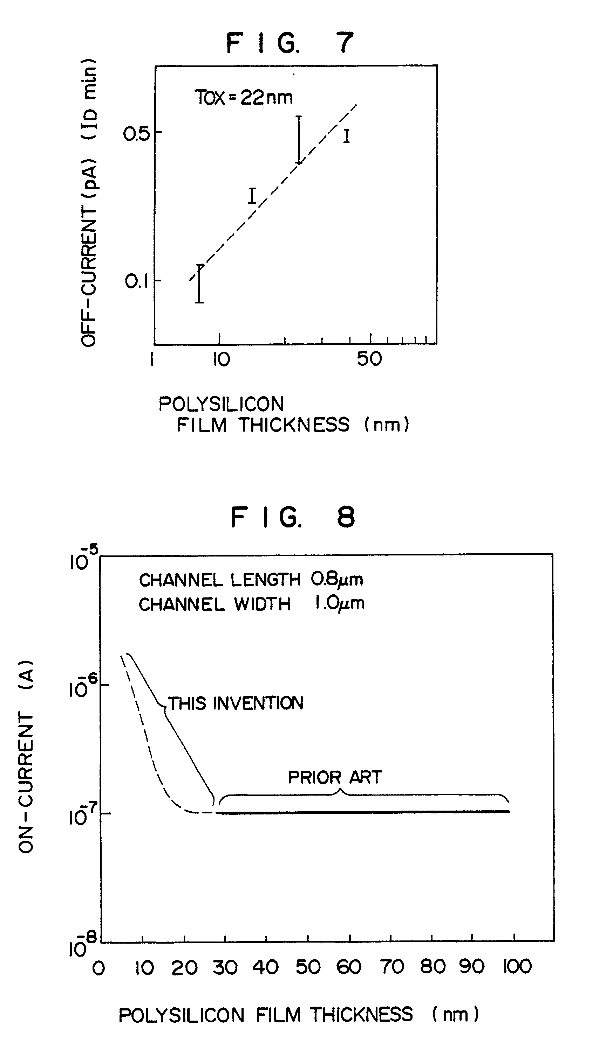

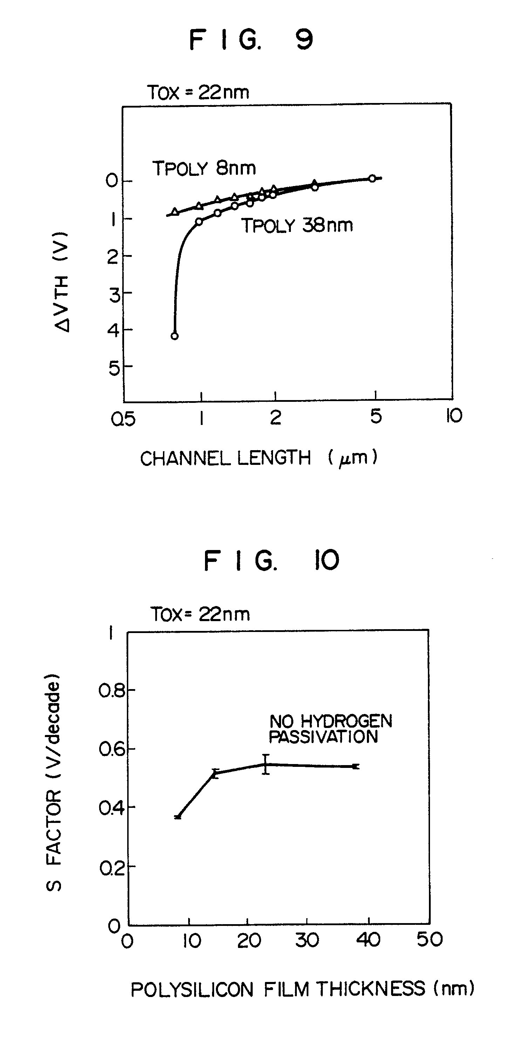

The similar measurements were executed and the results were compared with respect to the case where the thickness of polycrystalline silicon film as a channel region was set to 40 nm, which is a thin film limit value due to the conventional method, and the case where it was set to 30 nm or less which could be realized by the present invention. Figs. 6 to 10 are diagrams showing the effects of the invention, respectively. Fig. 6 is a diagram showing the characteristics of a drain current $I_D$ and a gate voltage $V_G$. Fig. 7 is a diagram showing the dependency of an off-current to a polycrystalline silicon film thickness. Fig. 8 is a diagram showing the dependency of an on-current to a polycrystalline silicon film thickness. Fig. 9 is a diagram showing the improvement of a short channel effect by the realization of a thin polycrystalline silicon film. Fig. 10 is a diagram showing the improvement of the subthreshold characteristics by the realization of a thin polycrystalline silicon film.

The following points could be known from the above diagrams. By making the polycrystalline silicon film thin until 10 nm, the off-current was reduced into 1/5. On the other hand, the absolute value of the threshold voltage was reduced by one volt. The subthreshold characteristics were also improved and the S factor was reduced into 1/2. Thus, the on-current was increased by one digit. Further, the short channel effect was also fairly improved. In the case of a film thickness of 40 nm, when the channel length is 1.4 $\mu$m or less, the off-current was increased due to the punchthrough. On the other hand, in the case of a film thickness of 10 nm, even when the channel length is set to 0.8 $\mu$m, no punchthrough was found.

Embodiment 2

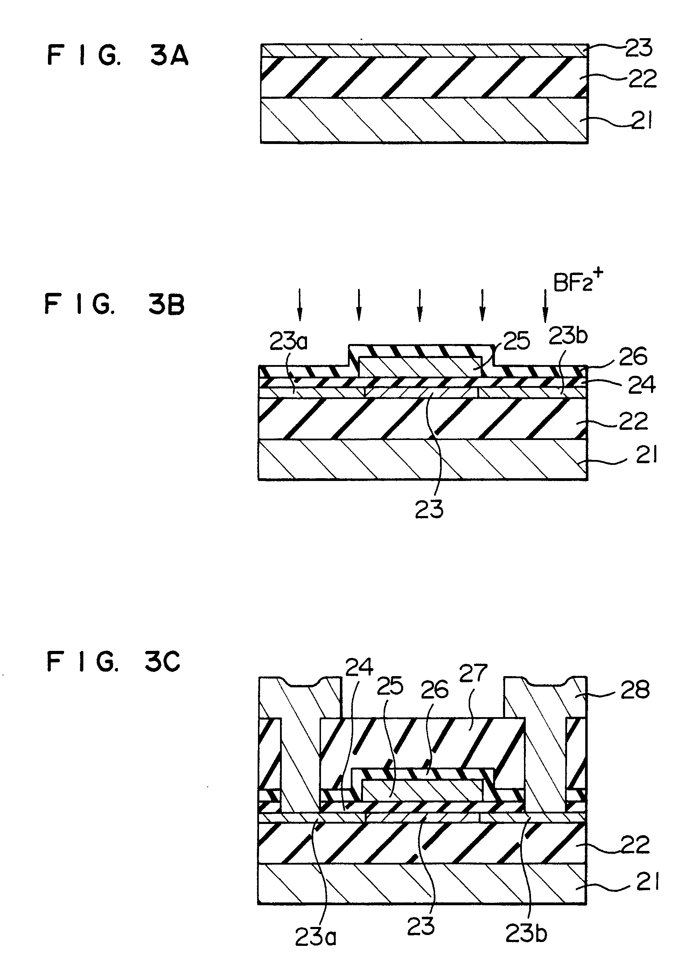

The MISFET shown in the embodiment 1 has a structure in which the gate insulative film is formed on the gate electrode. In addition to the above structure, there is a structure in which a gate electrode is formed on a gate insulative film. The embodiment 2 relates to an example in the case where the invention is embodied to the MISFET having the latter structure and will now be described with reference to Figs. 3A to 3C.

First, an $SiO_2$ film 22 having a thickness of 100 nm to 1 $\mu$m is deposited onto a p type Si substrate 21 at a temperature of 800°C by the LPCVD method by using an $SiH_4$ gas and an $N_2O$ gas. Then, a gas of the silane system ($SiH_4$, $Si_2H_6$, or $Si_3H_8$) is used as a source gas and an Si film 23 of a thickness of 10 nm is deposited at a temperature of 520°C by the LPCVD method (Fig. 3A). An $SiO_2$ film 24 of a thickness of 25 nm is deposited by using the LPCVD method and the heat treatment is executed in the $N_2$ gas atmosphere at 900°C for ten minutes, thereby forming a gate oxide film. A polycrystalline silicon film is deposited on the gate oxide film by the LPCVD method. A photo resist pattern is used as a mask and the dry etching is executed, thereby forming a gate electrode 25. An $SiO_2$ film 26 is deposited onto the gate electrode 25 by the LPCVD method. Ions of $BF_2{}^+$ are implanted into the polycrystalline silicon films 23 and 25 and a source 23a, a drain 23b, and a gate electrode are simultaneously formed (Fig. 3B).

An $SiO_2$ film is formed by the CVD method. A BPSG layer is deposited onto the $SiO_2$ film by the CVD method, thereby forming an interlayer insulative film 27. After the reflow was executed, a photo resist pattern is used as a mask and a contact is formed by the dry etching method. Then, an Al-Si film 28 is deposited, a photo resist pattern is used as a mask and a wiring pattern is formed by the dry etching method. After that, the heat treatment is performed in the $H_2$ gas atmosphere at 450°C for 30 minutes (Fig. 3C).

In the p channel MOSFET of polycrystalline silicon which was manufactured by the embodiment, the measurement similar to that in the embodiment 1 was executed. Thus, the characteristics could be remarkably improved in a manner similar to the embodiment 1.

Embodiment 3

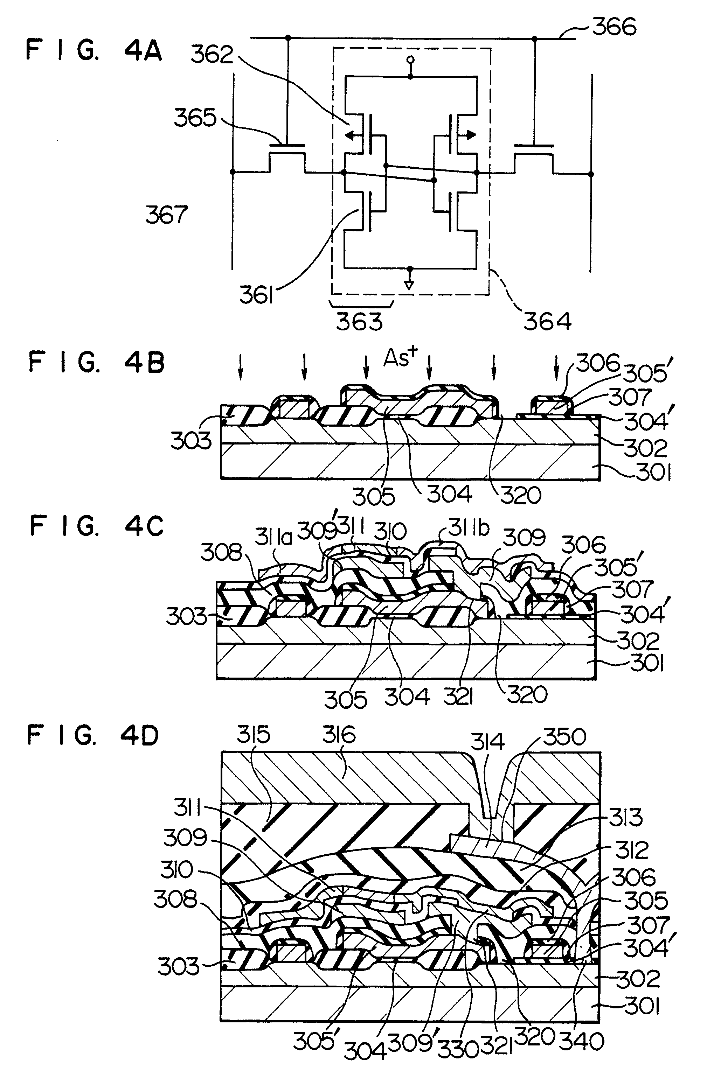

An embodiment in which the invention was applied to a memory cell of the SRAM of the complete CMOS type will now be described with reference to Figs. 4A to 4D. Fig. 4A shows an equivalent circuit diagram of the memory cell. The memory cell comprises: a fli-flop circuit 364 which is constructed by a pair of CMOS inverters 363 each consisting of a driver nMOS transistor 361 and a polycrystalline silicon pMOS transistor 362; transfer nMOS transistors 365 connected to output terminals; and a word line 366 and data lines 367 which are connected to the transfer nMOS transistors 365.

A manufacturing method of the memory cell will now be described hereinbelow.

First, an n type monocrystalline Si substrate 301 is prepared. B ions are implanted into the substrate 301 and the thermal annealing is executed, thereby forming a p well 302. Then, a device isolation region 303 is formed by a selective oxidation method (LOCOS method).

After gate oxide films 304 and 304' for the driver MOS transistor and transfer MOS transistor were formed by the thermal oxidation, ions of $BF_2^+$ are implanted into the lower regions of the gate oxide films 304 and 304' in order to adjust the threshold voltages of the MOS transistors.

A contact 320 is formed to directly connect the gate electrode of the driver MOS transistor and the doped region of the transfer MOS transistor. A polycrystalline silicon layer is deposited by the LPCVD method. Phosphorus is doped by using $POCl_3$. After that, an $SiO_2$ film 306 is deposited by the LPCVD method. A resist having a desired pattern is used as a mask (not shown) and a gate electrode 305 of the driver MOS transistor and a gate electrode 305' of the transfer MOS transistor are formed by the dry etching method. Then, $P^+$ ions are implanted to form a low concentration region for an LDD structure. An $SiO_2$ film is then deposited by the LPCVD method. Side walls 307 are formed on the side walls of the gate electrodes 305 and 305' by the well-known anisotropic dry etching. As$^+$ ions are implanted. High concentration impurity regions (not shown) serving as a source and a drain of each of the MOS transistors are formed. (Fig. 4B)

After the impurities were activated, an interlayer $SiO_2$ film 308 is deposited by the LPCVD method. Subsequently, a contact 321 is formed to connect the gate electrode of the polycrystalline silicon p channel MOS transistor and the gate electrode 305 of the driver MOS transistor. After that, a polycrystalline silicon film is deposited by the LPCVD method. Then, after an $SiO_2$ film was deposited by the LPCVD method. $BF_2^+$ ions are implanted into the polycrystalline silicon film and the impurities are activated. Then, the $SiO_2$ film is eliminated by the wet etching method. Thereafter, a photo resist having a desired pattern is used as a mask and a polycrystalline silicon film is processed into a predetermined shape by the dry etching method, thereby forming gate electrodes 309 and 309' of the polycrystalline silicon p channel MOS transistor. An $SiH_4$ gas and an $N_2O$ gas are used as source gases, an $SiO_2$ film having a thickness of 25 nm is deposited at a temperature of 800°C by the LPCVD method, and a heat treatment is executed at 900°C for 10 minutes in the $N_2$ gas atmosphere, thereby forming a gate oxide film 310. Then, a contact is formed to connect the gate electrodes 309 and 309' of each of the inverters which face the doped region of the drain portion of the polycrystalline silicon p channel MOS transistor. After that, a silane gas ($SiH_4$, $Si_2H_6$, or $Si_3H_8$) is used as a source gas and an Si film 311 of a thickness of 10 nm is deposited at a temperature of 520°C by the LPCVD method. A photo resist is used as a mask, the Si film 311 is processed into a predetermined shape by the dry etching method, an $SiO_2$ film is deposited by the LPCVD method, a photo resist is used as a mask, $BF_2^+$ ions are implanted into a predetermined region, and thereby forming a source region 311a and a drain region 311b. (Fig. 4C)

An $SiO_2$ film 312 is then deposited by the LPCVD method. A BPSG film 313 is deposited onto the $SiO_2$ film 312 by the atmospheric pressure CVD method, thereby forming an interlayer insulative film. Subsequently, a contact 340 for the doped region of the transfer MOS transistor is formed and, thereafter, TiN and W are evaporation deposited and processed into a predetermined shape by the dry etching method, thereby forming a first layer wiring. Then, an $SiO_2$ film 315 containing phosphorus is deposited as a wiring interlayer insulative film and a contact 350 of a second layer wiring is formed. After that, TiN and Al are evaporation deposited and processed into a predetermined shape by the dry etching method, thereby forming a data line 316 as a second layer wiring (Fig. 4D).

Finally, a heat treatment is executed in the $H_2$ gas atmosphere at 450°C for 30 minutes. Then, a silicon nitride film (not shown) is deposited as a final protective film by the plasma CVD method using an $SiH_4$ gas and an $NH_3$ gas and processed into a predetermined shape by the dry etching method. Thereafter, a heat treatment is executed in the $N_2$ gas atmosphere at 400°C for 60 minutes.

An amount of current consumption in the standby mode of the memory cell which was manufactured by the above method was 1/5 of that of the memory cell which was manufactured by the conventional technique. On the other hand, as the result of that the on-current was increased due to the thin-film effect, the data retention characteristics were improved and the soft error ratio in the operative mode was also remarkably reduced.

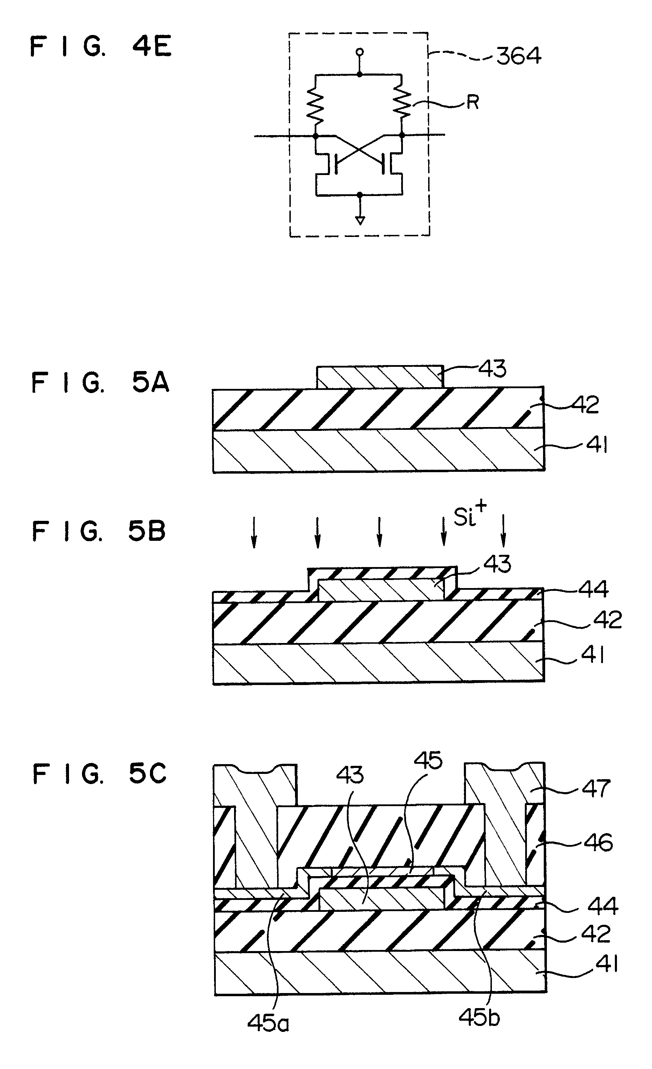

As shown in Fig. 4E, the flip-flop circuit 364 can be also constructed by polycrystalline silicon high resistors R and NMOS transistors.

Embodiment 4

In the embodiments 1 to 3, the CVD insulative film has been used as an under insulative film in place of the thermal oxide film in order to deposit an ultra-thin Si film having a thickness of 30 nm or less. There will be shown an example in which in the case of using a thermal oxide film in a manner similar to the conventional technique to obtain the effect similar to that mentioned above, $Si^+$ ions are implanted and the nucleus generation density in the surface is raised and a continuous film is formed.

A p type Si substrate 41 is prepared and an $SiO_2$ film 42 and a polycrystalline silicon gate electrode 43 are formed in the same method as that in the embodiment 1 (Fig. 5A).

The surface of the polycrystalline silicon gate electrode 43 is thermally oxidized at a temperature of 900°C and an $SiO_2$ film 44 having a thickness of 25 nm is formed. Subsequently, $Si^+$ ions are implanted at 15 keV and by $1 \times 10^{16}$ $cm^{-2}$ (Fig. 5B). then, an Si film 45 is deposited by the same method as that in the embodiment 1. After that, a source region 45a and a drain region 45b are formed by implanting $BF_2^+$ ions. An interlayer film 46 of $BPSG/CVDSiO_2$ is formed, a contact is formed, and the annealing is executed in the $H_2$ gas atmosphere (Fig. 5C).

In the polycrystalline silicon p channel MOSFET which was manufactured by the embodiment, the characteristics similar to those in the embodiment 1 were obtained. Although the embodiment has been shown with respect to an example in which Si ions were implanted, the similar effect could be also obtained even in the case of implanting ions of F, Ar, As, P, B, or the like.

As described above, according to the manufacturing method of the invention, an ultra-thin Si film having a thickness of 30 nm or less can be formed onto the insulative film by the LPCVD method as a continuous film instead of an island-like portion.

On the other hand, according to the semiconductor device of the invention, the resistivity of the high polycrystalline silicon resistor can be increased and the off-current of the MISFET can be reduced into 1/5 of that of the conventional resistor. In addition, the S factor of the MISFET can be reduced into 1/2 and, further, no punchthrough is caused until the channel length of 0.8 um. Further, the amount of current consumption of the SRAM in the standby mode can be reduced into 1/5 and the soft error ratio can be also remarkably reduced.

## Claims

1. A semiconductor memory device having a substrate (11, 21, 41, 301) and a polycrystalline silicon film (13) of a thickness of 30 nm or less which is formed on said substrate and has a predetermined shape.

2. The device of claim 1, wherein said polycrystalline silicon film (13) is a high polycrystalline silicon resistor (R).

3. The device of claim 2, including a driver MIS type transistor (361) of said high polycrystalline silicon resistor.

4. The device of claim 3, comprising a flip-flop circuit (364) which is constructed by a pair of inverters (363) each of which is composed of said driver MIS type transistor (361) and said high polycrystalline silicon resistor (R).

5. The device of claim 1, including a polycrystalline silicon MIS type FET (362) having said polycrystalline silicon film (362) as a channel.

6. The device of claim 5, wherein said polycrystalline silicon MIS type FET (362) includes:
a substrate (21);
an insulative film formed on said substrate;
a gate (25) having a desired shape which is formed on said insulative film;
a gate insulative film formed so as to cover said gate;
said polycrystalline silicon film (23) formed on said gate insulative film; and
a source (23a) and a drain (23b) which are formed in said polycrystalline silicon film so as to sandwich said gate and to be away from each other.

7. The device of claim 5, wherein said polycrystalline silicon MIS type FET (362) includes:
a substrate (21);

an insulative film formed on said substrate;
said polycrystalline silicon film (23) formed on said insulative film;
a gate insulative film formed on said polycrystalline silicon film;
a gate (25) having a desired shape which is formed on said gate insulative film; and
a source (23a) and a drain (23b) which are formed in the polycrystalline silicon film so as to sandwich said gate and to be away from each other.

8. The device of any one of claims 5 to 7, including a driver MIS type transistor (361) to drive said polycrystalline silicon MIS type FET (362).

9. The device of claim 8, comprising a flip-flop circuit (364) which is constructed by a pair of inverters (363) each of which is composed of said driver MIS type transistor (361) and said polycrystalline silicon MIS type transistor (362).

10. The device of claim 4 or 9, comprising: transfer MIS type transistors (365) to transfer an output of said flip-flop circuit (364); and a word line (366) and data lines (367) which are respectively connected to gates and drain regions of said transfer MIS type transistors (365).

11. The device of claim 1, wherein at least a part of said polycrystalline silicon film (13) is a substantially non-doped region.

12. A method of manufacturing a semiconductor device, comprising the steps of:
forming an under insulative film (12) onto a substrate (11, 21, 41, 301) by using a chemical vapor deposition method; and
depositing a polycrystalline silicon film (13) of a thickness of 30 nm or less onto said under insulative film by using the chemical vapor deposition method.

13. A method of manufacturing a semiconductor device, comprising the steps of:
implanting Si ions into an under insulative film (12); and
depositing a polycrystalline silicon film (13) of a thickness of 30 nm or less onto said under insulative film.

14. The method of claim 12 or 13, wherein one kind of monosilane, disilane, and trisilane is used as a source gas to deposite said polycrystalline silicon film (13).

15. A method of manufacturing a semiconductor device, comprising the steps of:
forming an insulative film onto a substrate (21) by using a chemical vapor deposition method;
forming a gate (25) having a desired shape onto said insulative film;
forming a gate insulative film so as to cover said gate (25);
forming a substantially non-doped polycrystalline silicon film (23) having a thickness of 30 nm or less by using the chemical vapor deposition method;

and
forming a source (23a) and a drain (23b) by doping impurities into regions which are away from each other in said polycrystalline silicon film (23) so as to sandwich said gate.

16. A method of manufacturing a semiconductor device, comprising the steps of:
forming an insulative film onto a substrate (21);
implanting Si ions into said insulative film;
forming a substantially non-doped polycrystalline silicon film (23) of a thickness of 30 nm or less onto said insulative film by using a chemical vapor deposition method;
forming a gate insulative film onto said polycrystalline silicon film;
forming a gate (25) having a desired shape onto said gate insulative film; and
forming a source (23a) and a drain (23b) by doping impurities into regions which are away from each other in said polycrystalline silicon film so as to sandwich said gate.

# F I G. 1

F I G. 2A

$BF_2^+$

14
13
12
11

F I G. 2B

16a  16  13′  16b

17
15
12
11

F I G. 2C

16a 16  13′  16b

19
18
15
12
11

F I G.  3A

F I G.  3B

$BF_2{}^+$

F I G.  3C

F I G. 4A

F I G. 4B

F I G. 4C

F I G. 4D

F I G. 4E

364

R

F I G. 5A

43

42

41

F I G. 5B

↓ ↓ ↓ ↓Si⁺ ↓

43

44

42

41

F I G. 5C

43 45

47

46

44

42

41

45a 45b

# F I G. 6

VD = −3V, W = 0.6 μm

DRAIN CURRENT (A)

decade /div

L=0.8 μm

L=5 μm

Poly Si 40nm

Poly Si 10nm

−1E−06.

−1E−14

5.000 — 0 — −5.000

GATE VOLTAGE 1.000/div (V)

## F I G. 7

POLYSILICON
FILM THICKNESS (nm)

## F I G. 8

POLYSILICON FILM THICKNESS (nm)

EP 0 397 034 A1

# F I G. 9

TOX = 22nm

# F I G. 10

TOX = 22nm

EP 90 10 8387

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 5) |
|---|---|---|---|
| X | DE-A-2 916 426 (HITACHI LTD.) <br> * pages 18,20; figures 1,15 * | 1-4,11 | H 01 L 27/105 <br> H 01 L 27/11 <br> H 01 L 21/82 <br> H 01 L 29/784 <br> G 11 C 11/412 |
| A | --- | 12 | |
| X | EP-A-0 152 625 (SONY CORP.) <br> * page 5, line 14 - page 6, line 12; figure 1; claims 1-5,7-10,12-14 * | 1-3,5, 11 | |
| Y | | 6-10,12 ,14,15 | |
| A | --- | 16 | |
| Y | EP-A-0 222 215 (HITACHI LTD.) <br> * column 4, line 37 - column 5, line 28; column 6, lines 1-28; figures 1A-1E,3 * | 7-10,12 ,14 | |
| A | --- | 5,16 | |
| Y | INTERNATIONAL ELECTRON DEVICES MEETING TECHNICAL DIGEST 1988 <br> 11-14 December 1988, pages 48-51, San Francisco, CA,US; T. YAMANAKA et al.: "A 25 squaremicrometre new poly-Si PMOS load (PPL) SRAM cell having excellent soft error immunity" * page 48, right column; page 49, figures 1,3,5; abstract * | 6,15 | |
| A | idem | 1-5,11, 12 | TECHNICAL FIELDS SEARCHED (Int. Cl.5) <br><br> H 01 L <br> G 11 C |
| | ---      -/- | | |

The present search report has been drawn up for all claims

| Place of search | Date of completion of the search | Examiner |
|---|---|---|
| BERLIN | 16-07-1990 | KLOPFENSTEIN P R |

EPO FORM 1503 03.82 (P0401)

European Patent
Office

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | IEEE TRANSACTIONS ON MAGNETICS vol. SC20, no. 1, February 1985, pages 178-201, New York, US; S.D.S. MALHI et al.: "Characteristics and three-dimensional integration of MOSFET's in small grain LPCVD polycristalline Silicon" * page 188, paragraph B; figures 4,19 * | 1,5-7, 11-16 | |
| Y | IEEE JOURNAL OF SOLID-STATE CIRCUITS vol. SC15, no. 2, April 1980, pages 201-205, New York, US; &. OHZON et al.: "A 2K x 8-Bit Static MOS RAM with a New Memory Cell Structure" * pages 202,203,left column; figures 2,3 * | 14 | |
| A | idem | 1-4,6, 10-12, 15 | |
| A | PHILIPS TECHNICAL REVIEW vol. 44, no. 2, April 1988, pages 33-42, Eindhoven, NL; J.J.J. BASTIAENS et al.: "The 256-kbit SRAM: an important step on the way to submicron IC technology" * page 35, right column; page 37, left column; figures 4a,4b * | 1-5,8-10 | TECHNICAL FIELDS SEARCHED (Int. Cl.5) |

The present search report has been drawn up for all claims

| Place of search | Date of completion of the search | Examiner |
|---|---|---|
| BERLIN | 16-07-1990 | KLOPFENSTEIN P R |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
                          
& : member of the same patent family, corresponding document

EPO FORM 1503 03.82 (P0401)